# EUROPEAN PATENT APPLICATION

(11) **EP 4 557 914 A1**
(43) Date of publication of application: **21.05.2025**
(21) Application number: 24213156.3
(22) Date of filing: 15.11.2024
(51) Int. Cl.: H10D 89/60, H02H 9/04

(54) **ELECTROSTATIC DISCHARGE PROTECTION CIRCUIT**

(30) Priority: 17.11.2023 TW 112144579
(71) Applicant: RichWave Technology Corp., Taipei City 114 (TW)
(72) Inventor: Pai, Ching-Yao, 114 Taipei City (TW); Chen, Yu-Hung, 114 Taipei City (TW)
(74) Representative: Straus, Alexander

(57) **Abstract**

An electrostatic discharge protection circuit (200) includes a main transistor (B21), a resistor element (R21) and a control circuit (210). A first voltage terminal (PAD21) is coupled to a second terminal of the main transistor (B21) and a first terminal of the resistor element (R21). A second voltage terminal (PAD22) is coupled to a first terminal of the main transistor (B21). The control circuit (210) is coupled between a second terminal of the resistor element (R21) and a control terminal of the main transistor (B21). When an electrostatic discharge event occurs, the product of the capacitance value of a parasitic capacitance (Cgs) of the control circuit (210) and the resistance value of the resistor element (R21) is greater than the duration of the electrostatic discharge event, and the control circuit (210) turns on the main transistor (B21) so that an electrostatic discharge current flows through the main transistor (B21).

## Description

### Field of the Invention

The present disclosure relates to an integrated circuit, and in particular to an electrostatic discharge (ESD) protection circuit.

### Background of the Invention

Electrostatic discharge (ESD) is one of the many factors that causes electrical overstress (EOS) which damages integrated circuits. ESD might permanently damage the semiconductor elements in the integrated circuit, and affect the function of the integrated circuit (or even failing to work properly). How to prevent ESD from damaging integrated circuits is one of the many technical issues to be solved in this field.

### Summary of the Invention

The present disclosure aims at providing an electrostatic discharge protection circuit which can prevent electrostatic discharge (ESD) from damaging integrated circuits. This is achieved by the ESD protection circuit according to claim 1. The dependent claims pertain to corresponding further developments and improvements.

### Brief Description of the Drawings

FIG. 1 is a circuit block diagram of an electrostatic discharge (ESD) protection circuit according to an embodiment;
FIG. 2 is a circuit block diagram of an ESD protection circuit according to an embodiment of the disclosure;
FIG. 3 is a circuit block diagram of an ESD protection circuit according to another embodiment of the disclosure;
FIG. 4 is a circuit block diagram of an ESD protection circuit according to still another embodiment of the disclosure;
FIG. 5 is a circuit block diagram of an ESD protection circuit according to yet another embodiment of the disclosure;
FIG. 6 is a circuit block diagram of an ESD protection circuit according to still another embodiment of the disclosure;
FIG. 7 is a circuit block diagram of an ESD protection circuit according to yet another embodiment of the disclosure;
FIG. 8 is a circuit block diagram of an ESD protection circuit according to still another embodiment of the disclosure; and
FIG. 9 is a circuit block diagram of a pull-down circuit according to an embodiment of the disclosure.

### Detailed Description

The term "coupling (or connection)" used throughout the specification of the disclosure (including the claims of the disclosure) can refer to any direct or indirect means of connection. For example, if a first device is coupled (or connected) to a second device, it should be construed that the first device can be directly connected to the second device, or the first device can be indirectly connected to the second device through other devices or through some means of connection. The terms "first" and "second" mentioned throughout the specification of the disclosure (including claims) are used to name elements or to distinguish different embodiments or scopes, and are neither used to restrict the upper or lower limits of the number of elements, nor to limit the order of components. In addition, wherever possible, elements/components/steps with the same reference numbers are used in the drawings and embodiments to represent the same or similar parts. Elements/components/steps using the same numbers or using the same terms in different embodiments may serve as cross-reference for each other.

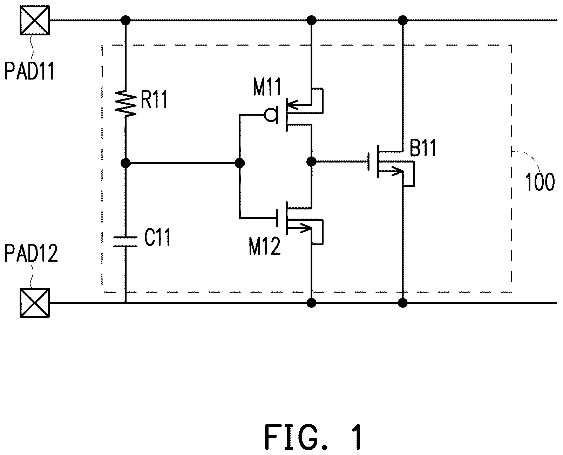

FIG. 1 is a circuit block diagram of an electrostatic discharge (ESD) protection circuit 100 according to an embodiment. The ESD protection circuit 100 may be configured in an integrated circuit. The ESD protection circuit 100 shown in FIG. 1 is coupled between the voltage terminal PAD11 and the voltage terminal PAD12. The voltage terminals PAD11 and PAD12 may be bonding pads or other types of connection pads. In some application examples, the voltage terminal PAD11 is configured to transmit the system voltage (such as VDD), and the voltage terminal PAD12 is configured to transmit the reference voltage (such as VSS). In other application examples, the voltage terminal PAD11 is configured to transmit input/output data (or input/output signals) of the integrated circuit.

The ESD protection circuit 100 shown in FIG. 1 includes a resistor R11, a capacitor C11, a transistor M11, a transistor M12 and a main transistor B11. The voltage terminal PAD 12 is coupled to the first terminal of the capacitor C11, the first terminal (e.g., the source) of the transistor M12, and the first terminal (e.g., the source) of the main transistor B11. The voltage terminal PAD11 is coupled to the first terminal of the resistor R11, the first terminal (such as the source) of the transistor M11 and the second terminal (such as the drain) of the main transistor B11. The second terminal of the resistor R11 and the second terminal of the capacitor C11 are coupled to the control terminal (such as the gate) of the transistor M11 and the control terminal (such as the gate) of the transistor M12. The second terminal (e.g., drain) of the transistor M11 and the second terminal (e.g. drain) of the transistor M12 are coupled to the control terminal (e.g., gate) of the main transistor B 11.

In the normal operating mode of the integrated circuit, the resistor R11 and the capacitor C11 may provide a high logic voltage to the control terminals of the transistors M11 and M12, thereby turning on the transistor M12 and turning off the transistor M11 and the main transistor B11. Therefore, the ESD protection circuit 100 will not affect the normal operation of the integrated circuit. When an ESD event (taking a positive pulse as an example) occurs at the voltage terminal PAD11, the resistor R11 and the capacitor C11 may provide low voltage to the control terminals of the transistors M11 and M12, thereby turning off the transistor M12 and turning on the transistor M11 and the main transistor B11. Under this condition, the main transistor B11 may transmit the ESD current of the voltage terminal PAD11 to the voltage terminal PAD12. Therefore, the ESD protection circuit 100 may prevent ESD from damaging the integrated circuit. Generally speaking, the capacitor C11 occupies a large area of the integrated circuit.

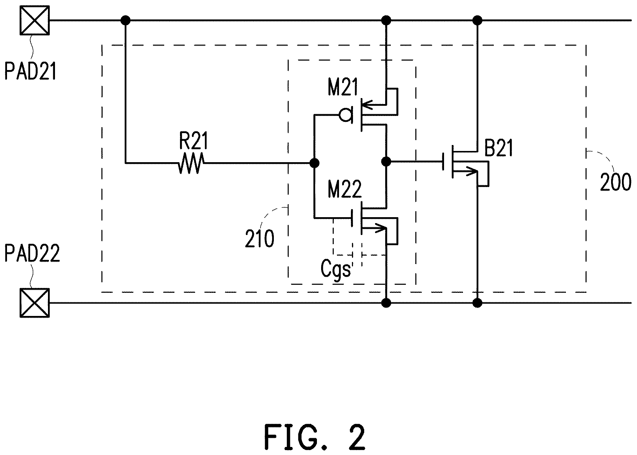

FIG. 2 is a circuit block diagram of an ESD protection circuit 200 according to an embodiment of the present disclosure. The ESD protection circuit 200 may be configured in an integrated circuit. The ESD protection circuit 200 is coupled between the voltage terminal PAD21 and the voltage terminal PAD22. The voltage terminals PAD21 and PAD22 may be bonding pads or other types of connection pads. In some application examples, the voltage terminal PAD21 is configured to transmit the system voltage (such as VDD), and the voltage terminal PAD22 is configured to transmit the reference voltage (such as VSS). In other application examples, the voltage terminal PAD21 is configured to transmit input/output data (or input/output signals) of the integrated circuit.

The ESD protection circuit 200 shown in FIG. 2 includes a resistor element R21, a control circuit 210 and a main transistor B21. The main transistor B21 shown in FIG. 2 is, for example, an N-type transistor, that is, an N-channel Metal-Oxide-Semiconductor (NMOS) transistor, but which should not be construed as a limitation to other embodiments. The resistor element R21 is, for example, an actual resistor, or another element equivalent to a resistor, such as an active element or an inductor, wherein the active element is, for example, a Metal-Oxide-Semiconductor (MOS) (which may be an N-channel type or P-channel type) transistor, a field-effect transistor (FET), a bipolar junction transistor (BJT), a heterojunction bipolar transistor (HBT) or a diode. The voltage terminal PAD22 is coupled to the second terminal of the control circuit 210 and the first terminal (e.g., source) of the main transistor B21. The voltage terminal PAD21 is coupled to the first terminal of the resistor element R21, the first terminal of the control circuit 210 and the second terminal (e.g., drain) of the main transistor B21. The input terminal of the control circuit 210 is coupled to the second terminal of the resistor element R21. The output terminal of the control circuit 210 is coupled to the control terminal (e.g. gate) of the main transistor B21. When an ESD event occurs, the control circuit 210 may turn on the main transistor B21 so that the ESD current flows through the main transistor B21. In this embodiment, the ESD event is, for example, a positive pulse. The ESD current, for example, flows through the main transistor B21 from the voltage terminal PAD21 and is conducted to the voltage terminal PAD22. In other embodiments, the ESD event is, for example, a negative pulse. The ESD current may also flow through the main transistor B21 from the voltage terminal PAD22 and be conducted to the voltage terminal PAD21.

In the embodiment shown in FIG. 2, the control circuit 210 includes a control transistor M21 and a control transistor M22. The control transistor M21 shown in FIG. 2 is, for example, a P-type transistor, that is, a P-channel Metal-Oxide-Semiconductor (PMOS) transistor, and the control transistor M22 is, for example, an N-type transistor, that is, N-channel Metal-Oxide-Semiconductor (NMOS) transistor, but which should not be construed as a limitation to other embodiments. The sizes of the main transistor B21, the control transistor M21 and the control transistor M22 may be determined according to the actual design. For example, in some application examples, the size of the main transistor B21 is larger than the size of the control transistor M22. The first terminal (e.g., source) of the control transistor M21 is coupled to the first terminal of the control circuit 210. The control terminal (e.g., gate) of the control transistor M21 is coupled to the input terminal of the control circuit 210. The first terminal (e.g., source) of the control transistor M22 is coupled to the second terminal of the control circuit 210. The second terminal (e.g., drain) of the control transistor M22 is coupled to the second terminal (e.g., the drain) of the control transistor M21. The control terminal (e.g., gate) of the control transistor M22 is coupled to the input terminal of the control circuit 210. The second terminals of the control transistors M22 and M21 are coupled to the output terminal of the control circuit 210.

In the normal operating mode of the integrated circuit, the resistor element R21 may provide a high logic voltage to the control terminals of the control transistors M22 and M21, thereby turning on the control transistor M22 and turning off the control transistor M21 and the main transistor B21. Therefore, the ESD protection circuit 200 will not affect the normal operation of the integrated circuit. When an ESD event (taking a positive pulse as an example) occurs at the voltage terminal PAD21, the product of the capacitance value of the parasitic capacitance Cgs (effective capacitance between gate and source) of the control transistor M22 and the resistance value of the resistor element R21 is greater than the duration of the ESD event, the parasitic capacitance Cgs of the resistor element R21 and the control transistor M22 may provide low voltage to the control terminals of the control transistors M22 and M21, thereby turning off the control transistor M22 and turning on the control transistor M21 and the main transistor B21 (the potential at the output terminal of the control circuit 210 is high potential). Under this condition, the main transistor B21 may transmit the ESD current of the voltage terminal PAD21 to the voltage terminal PAD22. Therefore, the ESD protection circuit 200 may prevent ESD from damaging the integrated circuit. Compared with the embodiment shown in FIG. 1, the capacitor C11 may be omitted to save the area of the integrated circuit. In addition, the resistance value of the resistor element R21 may be an equivalent resistance value of the resistor element R21 when the ESD event occurs.

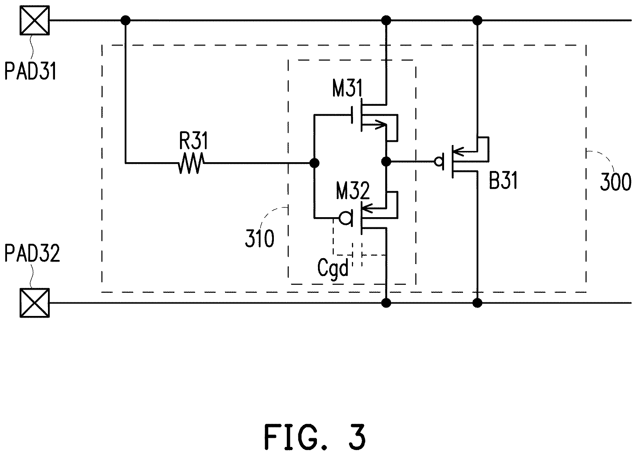

FIG. 3 is a circuit block diagram of an ESD protection circuit 300 according to another embodiment of the present disclosure. Reference for the voltage terminal PAD31, the voltage terminal PAD32 and the ESD protection circuit 300 shown in FIG. 3 may be derived from the relevant description of the voltage terminal PAD21, the voltage terminal PAD22 and the ESD protection circuit 200 shown in FIG. 2 and induced by analogy. The ESD protection circuit 300 shown in FIG. 3 includes a resistor element R31, a control circuit 310 and a main transistor B31. The main transistor B31 shown in FIG. 3 is, for example, a P-type transistor, that is, a PMOS transistor, but which should not be construed as a limitation to other embodiments. Reference for the resistor element R31, the control circuit 310 and the main transistor B31 shown in FIG. 3 may be derived from the relevant description of the resistor element R21, the control circuit 210 and the main transistor B21 shown in FIG. 2 and induced by analogy. When an ESD event occurs, the control circuit 310 may turn on the main transistor B31 so that the ESD current flows through the main transistor B31. In this embodiment, the ESD event is, for example, a positive pulse. The ESD current flows through the main transistor B31 from the voltage terminal PAD31 and is conducted to the voltage terminal PAD32. In other embodiments, the ESD event is, for example, a negative pulse. The ESD current may also flow through the main transistor B31 from the voltage terminal PAD32 and be conducted to the voltage terminal PAD31.

In the embodiment shown in FIG. 3, the control circuit 310 includes a control transistor M31 and a control transistor M32. The control transistor M32 shown in FIG. 3 is, for example, a P-type transistor, which is a PMOS transistor. The control transistor M31 is, for example, an N-type transistor, which is an NMOS transistor, but which should not be construed as a limitation to other embodiments. The sizes of the main transistor B31, the control transistor M32 and the control transistor M31 may be determined according to the actual design. For example, in some application examples, the size of the main transistor B31 is larger than the size of the control transistor M32. The first terminal (e.g., drain) of the control transistor M31 is coupled to the first terminal of the control circuit 310. The control terminal (e.g., gate) of the control transistor M31 is coupled to the input terminal of the control circuit 310. The first terminal (e.g., drain) of the control transistor M32 is coupled to the second terminal of the control circuit 310. The second terminal (e.g., the source) of the control transistor M32 is coupled to the second terminal (e.g., the source) of the control transistor M31. The control terminal (e.g., gate) of the control transistor M32 is coupled to the input terminal of the control circuit 310. The second terminals of the control transistors M32 and M31 are coupled to the output terminal of the control circuit 310.

In the normal operating mode of the integrated circuit, the resistor element R31 may provide a high logic voltage to the control terminals of the control transistors M31 and M32, thereby turning on the control transistor M31 and turning off the control transistor M32 and the main transistor B31. Therefore, the ESD protection circuit 300 will not affect the normal operation of the integrated circuit. When an ESD event (for example, a positive pulse) occurs at the voltage terminal PAD31, the product of the capacitance value of the parasitic capacitance Cgd (effective capacitance between gate and drain) of the control transistor M32 and the resistance value of the resistor element R31 is greater than the duration of the ESD event, the parasitic capacitance Cgd of the resistor element R31 and the control transistor M32 may provide low voltage to the control terminals of the control transistors M31 and M32, thereby turning off the control transistor M31 and turning on the control transistor M32 and the main transistor B31 (the potential at the output terminal of the control circuit 310 is low potential). In this condition, the main transistor B31 may transmit the ESD current of the voltage terminal PAD31 to the voltage terminal PAD32. Therefore, the ESD protection circuit 300 may prevent ESD from damaging the integrated circuit, and the capacitor C11 may also be omitted to save the area of the integrated circuit. In addition, the resistance value of the resistor element R31 may be an equivalent resistance value of the resistor element R31 when the ESD event occurs.

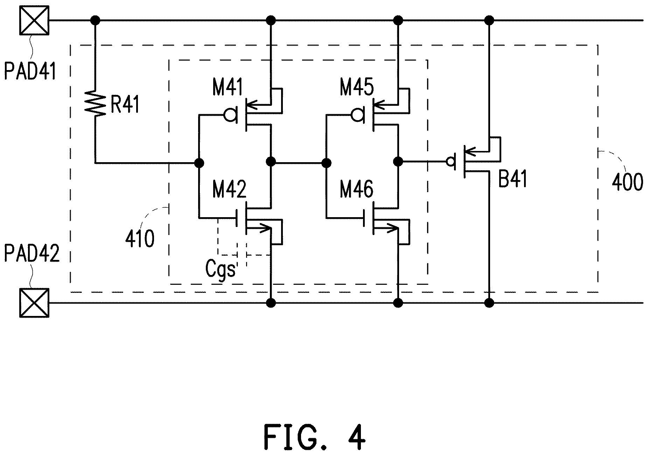

FIG. 4 is a circuit block diagram of an ESD protection circuit 400 according to yet another embodiment of the present disclosure. Reference for the voltage terminal PAD41, the voltage terminal PAD42 and the ESD protection circuit 400 shown in FIG. 4 may be derived from the relevant description of the voltage terminal PAD21, the voltage terminal PAD22 and the ESD protection circuit 200 shown in FIG. 2 and induced by analogy. The ESD protection circuit 400 shown in FIG. 4 includes a resistor element R41, a control circuit 410 and a main transistor B41. Reference for the resistor element R41, the control circuit 410 and the main transistor B41 shown in FIG. 4 may be derived from the relevant description of the resistor element R21, the control circuit 210 and the main transistor B21 shown in FIG. 2 and induced by analogy. When an ESD event occurs, the control circuit 410 may turn on the main transistor B41 so that the ESD current flows through the main transistor B41. In this embodiment, the ESD event is, for example, a positive pulse. The ESD current, for example, flows through the main transistor B41 from the voltage terminal PAD41 and is conducted to the voltage terminal PAD42. In other embodiments, the ESD event is, for example, a negative pulse. The ESD current may also flow through the main transistor B41 from the voltage terminal PAD42 and be conducted to the voltage terminal PAD41.

In the embodiment shown in FIG. 4, the control circuit 410 includes a control transistor M41, a control transistor M42, a control transistor M45 and a control transistor M46. The main transistor B41 shown in FIG. 4 is, for example, a P-type transistor, which is a PMOS transistor. The control transistors M41 and M45 are, for example, P-type transistors, which are PMOS transistors. The control transistors M42 and M46 are, for example, N-type transistors, which are NMOS transistors, but which should not be construed as a limitation to other embodiments. The sizes of the main transistor B41, the control transistor M41, the control transistor M42, the control transistor M45 and the control transistor M46 may be determined according to the actual design. For example, in some application examples, the size of the main transistor B41 is larger than the size of the control transistor M45. The first terminal (e.g., a source) of the control transistor M41 and the first terminal (e.g., a source) of the control transistor M45 are coupled to the first terminal of the control circuit 410. The control terminal (e.g., gate) of the control transistor M41 and the control terminal (e.g., gate) of the control transistor M42 are coupled to the input terminal of the control circuit 410. The first terminal (e.g., a source) of the control transistor M42 and the first terminal (e.g., a source) of the control transistor M46 are coupled to the second terminal of the control circuit 410. The second terminal (such as the drain) of the control transistor M42 and the second terminal (such as the drain) of the control transistor M41 are coupled to the control terminal (such as the gate) of the control transistor M46 and the control terminal (such as the gate) of the control transistor M45. The second terminals of the control transistors M45 and M46 are coupled to the output terminal of the control circuit 410.

In the normal operating mode of the integrated circuit, the resistor element R41 may provide a high logic voltage to the control terminals of the control transistors M42 and M41, thereby turning on the control transistors M42 and M45 and turning off the control transistor M41, the control transistor M46 and main transistor B41. In this way, the ESD protection circuit 400 will not affect the normal operation of the integrated circuit. When an ESD event (e.g., a positive pulse) occurs at the voltage terminal PAD41, the product of the capacitance value of the parasitic capacitance Cgs (effective capacitance between gate and source) of the control transistor M42 and the resistance value of the resistor element R41 is greater than the duration of the ESD event, and the parasitic capacitance Cgs of the resistor element R41 and the control transistor M42 may provide low voltage to the control terminals of the control transistors M42 and M41, thereby turning off the control transistors M42 and M45 and turning on the control transistor M41, the control transistor M46 and the main transistor B41 (the potential at the second terminals of the control transistors M41 and M42 is high potential, so that the potential at the output terminal of the control circuit 410 is low potential). In this condition, the main transistor B41 may transmit the ESD current of the voltage terminal PAD41 to the voltage terminal PAD42. Therefore, the ESD protection circuit 400 may prevent ESD from damaging the integrated circuit, and the capacitor C11 may be omitted to save the area of the integrated circuit. In addition, the resistance value of the resistor element R41 may be an equivalent resistance value of the resistor element R41 when the ESD event occurs.

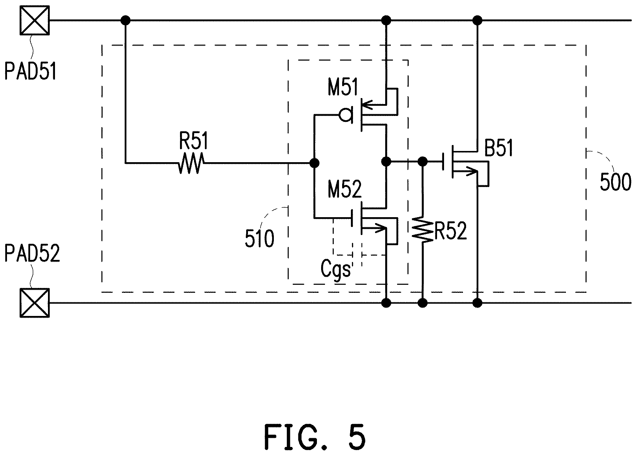

FIG. 5 is a circuit block diagram of an ESD protection circuit 500 according to still another embodiment of the present disclosure. Reference for the voltage terminal PAD51, the voltage terminal PAD52 and the ESD protection circuit 500 shown in FIG. 5 may be derived from the relevant description of the voltage terminal PAD21, the voltage terminal PAD22 and the ESD protection circuit 200 shown in FIG. 2 and induced by analogy. The ESD protection circuit 500 shown in FIG. 5 includes a resistor element R51, a control circuit 510 and a main transistor B51.

The control circuit 510 includes a control transistor M51 and a control transistor M52. Reference for the resistor element R51, the control circuit 510, the control transistor M51, the control transistor M52, and the main transistor B51 shown in FIG. 5 may be derived from the relevant description of the resistor element R21, the control circuit 210, the control transistor M21, the control transistor M22, and the main transistor B21 shown in FIG. 2 and induced by analogy, so the details will not be described again. When an ESD event occurs, the control circuit 510 may turn on the main transistor B51 so that the ESD current flows through the main transistor B51. In this embodiment, the ESD event is, for example, a positive pulse. The ESD current flows through the main transistor B51 from the voltage terminal PAD51 and is conducted to the voltage terminal PAD52. In other embodiments, the ESD event is, for example, a negative pulse. The ESD current may also flow through the main transistor B51 from the voltage terminal PAD52 and be conducted to the voltage terminal PAD51.

Different from the embodiment shown in FIG. 2, the ESD protection circuit 500 shown in FIG. 5 further includes a resistor element R52. The first terminal of the resistor element R52 is coupled to the control terminal of the main transistor B51. The second terminal of the resistor element R52 is coupled to the voltage terminal PAD52. In the normal operating mode, during the initialization stage of the integrated circuit, the system voltage from the voltage terminal PAD51 gradually rises but might not reach the voltage for turning on the control transistor M52, so the control transistor M52 cannot be turned on, thereby causing the potential at the output terminal of the control circuit 510 to be at a high potential. Under this condition, it is very likely to erroneously turn on the main transistor B51 (corresponding to the embodiment of FIG. 2, in the normal operating mode, the output terminal of the control circuit 210 must be at a low potential to turn off the main transistor B21); and adding the resistor element R52 may allow the output terminal of the control circuit 510 to maintain at the low potential in the normal operating mode, thereby preventing the main transistor B51 from being turned on erroneously. The resistance value of the resistor element R52 may be set according to the actual design. For example, in some application examples, the resistance value of the resistor element R52 is greater than or equal to 10 KS2 and less than or equal to 10 MS2. In a preferred embodiment, the resistor element R52 is less than or equal to 5 MS2. Furthermore, when an ESD event occurs, if the resistance value of the resistor element R52 is less than 10 KS2, the potential at the output terminal of the control circuit 510 may be zero, and the main transistor B51 cannot be turned on (correspondingly, refer to the embodiment of FIG. 2, when an ESD event occurs, the output terminal of the control circuit 210 must be at a high potential to turn on the main transistor B21).

In the normal operating mode, if the resistance value of the resistor element R52 is greater than 10 MS2, the output terminal of the control circuit 510 may be floating, that is, the resistor element R52 cannot function. Based on the relevant description of the resistor element R52 shown in FIG. 5, the resistor element R52 may be analogously configured in the ESD protection circuit shown in FIG. 1, FIG. 2, FIG. 3, FIG. 4, FIG. 6, FIG. 7, FIG. 8 or FIG. 9.

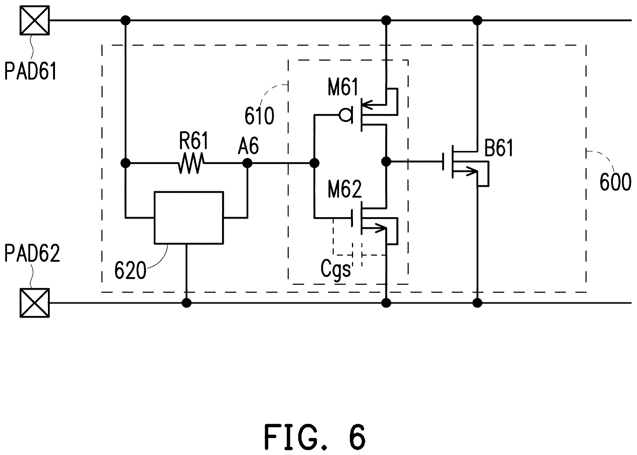

FIG. 6 is a circuit block diagram of an ESD protection circuit 600 according to yet another embodiment of the present disclosure. Reference for the voltage terminal PAD61, the voltage terminal PAD62 and the ESD protection circuit 600 shown in FIG. 6 may be derived from the relevant description of the voltage terminal PAD21, the voltage terminal PAD22 and the ESD protection circuit 200 shown in FIG. 2 and induced by analogy. The ESD protection circuit 600 shown in FIG. 6 includes a resistor element R61, a control circuit 610 and a main transistor B61. The control circuit 610 includes a control transistor M61 and a control transistor M62. Reference for the resistor element R61, the control circuit 610, the control transistor M61, the control transistor M62, and the main transistor B61 shown in FIG. 6 may be derived from the relevant description of the resistor element R21, the control circuit 210, the control transistor M21, the control transistor M22, and the main transistor B21 shown in FIG. 2 and induced by analogy, so the details will not be described again. When an ESD event occurs, the control circuit 610 may turn on the main transistor B61 so that the ESD current flows through the main transistor B61. In this embodiment, the ESD event is, for example, a positive pulse. The ESD current flows through the main transistor B61 from the voltage terminal PAD61 and is conducted to the voltage terminal PAD62. In other embodiments, the ESD event is, for example, a negative pulse. The ESD current may also flow through the main transistor B61 from the voltage terminal PAD62 and be conducted to the voltage terminal PAD61.

Different from the embodiment shown in FIG. 2, the ESD protection circuit 600 shown in FIG. 6 further includes a pull-down circuit 620. The pull-down circuit 620 is coupled between the input terminal A6 of the control circuit 610, the voltage terminal PAD61 and the voltage terminal PAD62. That is, the pull-down circuit 620 is coupled between the first terminal and the second terminal of the resistor element R61. When an ESD event occurs, the pull-down circuit 620 may pull down the potential at the input terminal A6 of the control circuit 610 and keep the potential at a low potential. The ESD energy from the voltage terminal PAD61 is gradually discharged, when the potential difference between the input terminal A6 of the control circuit 610 and the voltage terminal PAD61 is lower than the critical voltage, it means that the ESD event is over and the normal operating mode can be restored. The pull-down circuit 620 can change the potential at the input terminal A6 of the control circuit 610 from a low potential to a high potential to turn off the main transistor B61. In this way, in this embodiment, the ESD protection circuit 600 uses the pull-down circuit 620 to assist in pulling down the current during an ESD event, so that the potential at the input terminal A6 of the control circuit 610 is pulled down and maintained at a low potential, thereby turning on the main transistor B61 successfully during ESD events, so it is possible to more effectively prevent ESD from damaging integrated circuits.

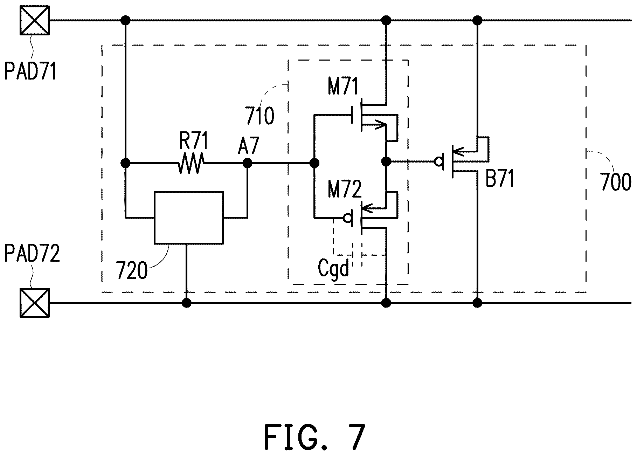

FIG. 7 is a circuit block diagram of an ESD protection circuit 700 according to still another embodiment of the present disclosure. Reference for the voltage terminal PAD71, the voltage terminal PAD72 and the ESD protection circuit 700 shown in FIG. 7 may be derived from the relevant description of the voltage terminal PAD21, the voltage terminal PAD22 and the ESD protection circuit 200 shown in FIG. 2 and induced by analogy. The ESD protection circuit 700 shown in FIG. 7 includes a resistor element R71, a control circuit 710, and a main transistor B71. The control circuit 710 includes a control transistor M71 and a control transistor M72. Reference for the resistor element R71, the control circuit 710, the control transistor M71, the control transistor M72 and the main transistor B71 shown in FIG. 7 may be derived from the description of the resistor element R31, the control circuit 310, the control transistor M31, the control transistor M32, and the main transistor B31 shown in FIG. 3 and induced by analogy, no further description will be given. When an ESD event occurs, the control circuit 710 may turn on the main transistor B71 so that the ESD current flows through the main transistor B71. In this embodiment, the ESD event is, for example, a positive pulse. The ESD current flows through the main transistor B71 from the voltage terminal PAD71 and is conducted to the voltage terminal PAD72. In other embodiments, the ESD event is, for example, a negative pulse. The ESD current may also flow through the main transistor B71 from the voltage terminal PAD72 and be conducted to the voltage terminal PAD71.

Different from the embodiment shown in FIG. 3, the ESD protection circuit 700 shown in FIG. 7 further includes a pull-down circuit 720. The pull-down circuit 720 is coupled between the input terminal A7 of the control circuit 710, the voltage terminal PAD71 and the voltage terminal PAD72. That is, the pull-down circuit 720 is coupled between the first terminal and the second terminal of the resistor element R71. When an ESD event occurs, the pull-down circuit 720 may pull down the potential at the input terminal A7 of the control circuit 710 and keep the potential at a low potential. The ESD energy from the voltage terminal PAD71 is gradually discharged, when the potential difference between the input terminal A7 of the control circuit 710 and the voltage terminal PAD71 is lower than the critical voltage, it means that the ESD event is over and the normal operating mode can be restored. The pull-down circuit 720 may change the potential at the input terminal A7 of the control circuit 710 from a low potential to a high potential to turn off the main transistor B71. In this way, in this embodiment, the ESD protection circuit 700 uses the pull-down circuit 720 to assist in pulling down the current during an ESD event, so that the potential at the input terminal A7 of the control circuit 710 is pulled down and maintained at a low potential, thereby turning on the main transistor B71 successfully during ESD events, so it is possible to more effectively prevent ESD from damaging integrated circuits.

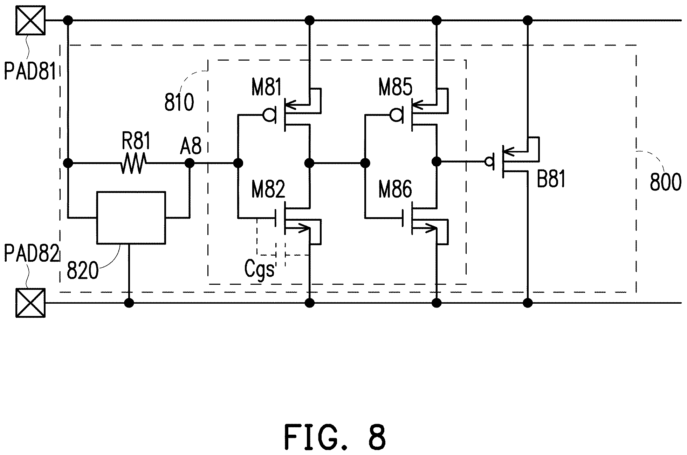

FIG. 8 is a circuit block diagram of an ESD protection circuit 800 according to still another embodiment of the disclosure. Reference for the voltage terminal PAD81, the voltage terminal PAD82 and the ESD protection circuit 800 shown in FIG. 8 may be derived from the relevant description of the voltage terminal PAD21, the voltage terminal PAD22 and the ESD protection circuit 200 shown in FIG. 2 and induced by analogy. The ESD protection circuit 800 shown in FIG. 8 includes a resistor element R81, a control circuit 810, and a main transistor B81. The control circuit 810 includes a control transistor M81, a control transistor M82, a control transistor M85, and a control transistor M86. Reference for the resistor element R81, the control circuit 810, the control transistor M81, the control transistor M82, the control transistor M85, the control transistor M86, and the main transistor B81 shown in FIG. 8 may be derived from the description of the resistor element R41, the control circuit 410, the control transistor M41, the control transistor M42, the control transistor M45, the control transistor M46, and the main transistor B41 shown in FIG. 4 and induced by analogy, no further description will be given. When an ESD event occurs, the control circuit 810 may turn on the main transistor B81 so that the ESD current flows through the main transistor B81. In this embodiment, the ESD event is, for example, a positive pulse. The ESD current, for example, flows through the main transistor B81 from the voltage terminal PAD81 and is conducted to the voltage terminal PAD82. In other embodiments, the ESD event is, for example, a negative pulse. The ESD current may also flow through the main transistor B81 from the voltage terminal PAD82 and be conducted to the voltage terminal PAD81.

Different from the embodiment shown in FIG. 4, the ESD protection circuit 800 shown in FIG. 8 further includes a pull-down circuit 820. The pull-down circuit 820 is coupled between the input terminal A8 of the control circuit 810, the voltage terminal PAD81 and the voltage terminal PAD82. That is, the pull-down circuit 820 is coupled between the first terminal and the second terminal of the resistor element R81. When an ESD event occurs, the pull-down circuit 820 may pull down the potential at the input terminal A8 of the control circuit 810 and keep the potential at a low potential. The ESD energy from the voltage terminal PAD81 is gradually discharged, when the potential difference between the input terminal A8 of the control circuit 810 and the voltage terminal PAD81 is lower than the critical voltage, it means that the ESD event is over and the normal operating mode can be restored. The pull-down circuit 820 may change the potential at the input terminal A8 of the control circuit 810 from a low potential to a high potential to turn off the main transistor B81. In this way, in this embodiment, the ESD protection circuit 800 uses the pull-down circuit 820 to assist in pulling down the current during an ESD event, so that the potential at the input terminal A8 of the control circuit 810 is pulled down and maintained at a low potential, thereby turning on the main transistor B81 successfully during ESD events, so it is possible to more effectively prevent ESD from damaging integrated circuits.

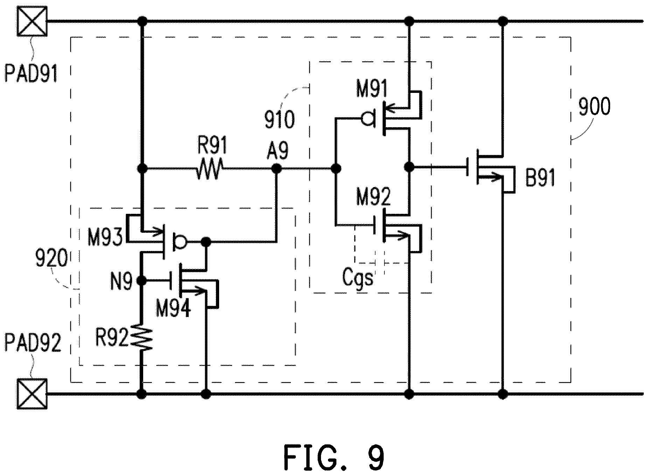

FIG. 9 is a circuit block diagram of a pull-down circuit 920 according to an embodiment of the disclosure. To further explain, FIG. 9 shows the voltage terminal PAD91, the voltage terminal PAD92, the resistor element R91, the control circuit 910, the pull-down circuit 920 and the main transistor B91. Reference for the voltage terminal PAD91, the voltage terminal PAD92, the resistor element R91, the control circuit 910 (including control transistor M91 and control transistor M92), the pull-down circuit 920 and the main transistor B91 shown in FIG. 9 may be derived from the relevant descriptions of the voltage terminal PAD61, the voltage terminal PAD62, the resistor element R61, the control circuit 610, the pull-down circuit 620 and the main transistor B61 shown in FIG. 6 and induced by analogy, or derived from the relevant description of the voltage terminal PAD71, the voltage terminal PAD72, the resistor element R71, the control circuit 710, the pull-down circuit 720, and the main transistor B71 shown in FIG. 7 and induced by analogy, or derived from the relevant descriptions of the voltage terminal PAD81, the voltage terminal PAD82, the resistor element R81, the control circuit 810, the pull-down circuit 820 and the main transistor B81 shown in FIG. 8 and induced by analogy. The pull-down circuit 920 shown in FIG. 9 may serve as one of the many embodiments of the pull-down circuit 620 shown in FIG. 6, or as one of the many embodiments of the pull-down circuit 720 shown in FIG. 7, or as one of the many embodiments of the pull-down circuit 820 shown in FIG. 8.

In the embodiment shown in FIG. 9, the pull-down circuit 920 includes a control transistor M93, a control transistor M94, and a resistor element R92. The resistor element R92 is, for example, an actual resistor, or another element equivalent to a resistor, such as an active element or an inductor, wherein the active element is, for example, a Metal-Oxide-Semiconductor (which is an N-channel type or a P-channel type) transistor, a field effect transistor, a bipolar junction transistor, a heterojunction bipolar transistor or a diode. The control transistor M93 shown in FIG. 9 is a P-type transistor, which is a PMOS transistor, and the control transistor M94 is an N-type transistor, which is an NMOS transistor, but which should not be construed as a limitation to the disclosure. The first terminal (for example, the source) of the control transistor M93 is coupled to the first terminal of the resistor element R91. The control terminal (e.g., gate) of the control transistor M93 is coupled to the input terminal A9 of the control circuit 910. The first terminal (e.g., source) of the control transistor M94 is coupled to the voltage terminal PAD92. The second terminal (e.g., drain) of the control transistor M94 is coupled to the input terminal A9 of the control circuit 910. The control terminal (e.g., gate) of the control transistor M94 is coupled to the second terminal (e.g., the drain) of the control transistor M93. The first terminal of the resistor element R92 is coupled to the second terminal of the control transistor M93 and the control terminal of the control transistor M94. The second terminal of the resistor element R92 is coupled to the voltage terminal PAD92. In addition, it should be noted that the pull-down circuits 620, 720, and 820 illustrated in FIG. 6, FIG. 7, and FIG. 8 are coupled to the voltage terminals PAD62, PAD72, and PAD82 through a node respectively, but this illustration only exemplarily shows that the pull-down circuits 620, 720, and 820 have a coupling relationship with the voltage terminals PAD62, PAD72, and PAD82 respectively, and the coupling method is not limited to one node only. FIG. 9 further illustrates the element that exemplifies the pull-down circuit 920 and an exemplary coupling relationship between the pull-down circuit 920 and the voltage terminal PAD92. In the exemplary coupling relationship, the resistor element R92 and the control transistor M94 are respectively coupled to the voltage terminal PAD92 through two nodes. Such coupling method may be applied to the embodiments of FIG. 6, FIG. 7, and FIG. 8.

In the normal operating mode of the integrated circuit, the potential difference between the input terminal A9 of the control circuit 910 and the voltage terminal PAD91 is quite small (lower than the critical voltage or even 0), so the control transistor M93 is turned off. When the control transistor M93 is turned off, the resistor element R92 may pull down the control terminal voltage of the control transistor M94 to a low logic level, so the control transistor M94 is turned off. In this condition, the pull-down circuit 920 will not affect the input terminal A9 of the control circuit 910.

When an ESD event (taking a positive pulse as an example) occurs at the voltage terminal PAD91, the parasitic capacitance (Cgs) of the resistor element R21 and the control transistor M92 may provide a low voltage to the input terminal A9 of the control circuit 910, thereby turning on the control transistor M93, that is to say, in this condition, the potential difference between the first terminal of the control transistor M93 and the input terminal A9 of the control circuit 910 is greater than the voltage for turning on the control transistor M93. When the control transistor M93 is turned on, the control transistor M93 may pull up the control terminal voltage of the control transistor M94 to a high logic level, so the control transistor M94 is turned on. The turned-on control transistor M94 may pull down and maintain the potential at the input terminal A9 of the control circuit 910 at a low potential, for example, the potential is pulled down to zero. In this condition, the main transistor B91 may serve as a small resistor when being turned on. When the ESD current flows through, the ESD voltage generated at the voltage terminal PAD91 may be pulled down and fixed at the clamping voltage. When the potential difference between the input terminal A9 of the control circuit 910 and the voltage terminal PAD91 is lower than the critical voltage of the control transistor M93, it means that the ESD event is over and the normal operating mode can be restored. The control transistors M93 and M94 are turned off, so the pull-down circuit 920 may change the potential at the input terminal A9 of the control circuit 910 from a low potential to a high potential to turn off the main transistor B91.

The resistance value of the resistor element R92 may be set according to the actual design. For example, in some application examples, the resistance value of the resistor element R92 is greater than or equal to 10 Ω and less than or equal to 10 MS2. In a preferred embodiment, the resistance value of the resistor element R92 is less than or equal to 5 MS2. Furthermore, when an ESD event occurs, if the resistance value of the resistor element R92 is less than 10 Ω, then the potential at the node N9 between the first terminal of the resistor element R92, the second terminal of the control transistor M93 and the control terminal of the control transistor M94 might be zero, as a result, the control transistor M94 cannot be turned on, and the potential at the input terminal A9 of the control circuit 910 cannot be pulled down and maintained at a low potential. In the normal operating mode, if the resistance value of the resistor element R92 is greater than 10 MS2, the node N9 may be floating. As a result, the resistor element R92 is likely to be coupled with other traces nearby, and therefore the pull-down circuit 920 is very likely to be affected by the signals on other traces, which is not desirable. In addition, the resistance value of the resistor element R92 may be the equivalent resistance value of the resistor element R92.

According to the above, in this embodiment, the control transistor M93, the control transistor M94 and the resistor element R92 of the pull-down circuit 920 are configured to assist in pulling current during the ESD event, so that the potential at the input terminal A9 of the control circuit 910 is pulled down and maintained at a low potential, so that the main transistor B81 is turned on successfully during an ESD event, making it more effectively to prevent ESD from damaging the integrated circuit. The control transistor M93 and the control transistor M94 are active elements and are controlled by voltage. Compared with the capacitor C11 used in the embodiment of FIG. 1, the control transistor M93 and the control transistor M94 pull down the potential at the input terminal A9 of the control circuit 910 faster. In addition, in some embodiments, the resistor element R92 may also be an active element, and the speed of pulling down the potential at the input terminal A9 of the control circuit 910 may be further accelerated through voltage control. Therefore, when the pull-down circuit 920 is adopted in the embodiments of FIG. 6, FIG. 7, and FIG. 8, the ESD protection circuits 600, 700, and 800 may be operated more quickly and effectively.

To sum up, in the above-mentioned embodiments, the product of the capacitance value of the parasitic capacitance (such as Cgs or Cgd) and the resistance value of the resistor element (such as R21, R31, R41, R51, R61, R71, R81 or R91) is greater than the duration of an ESD event, so parasitic capacitance and resistor element may serve as ESD detectors. When an ESD event occurs, the parasitic capacitance and resistor element may trigger the control circuit (such as 210, 310, 410, 510, 610, 710, 810 or 910) to turn on the main transistor (such as B21, B31, B41, B51, B61, B71, B81 or B91), so that the ESD current is transmitted between the first voltage terminal (such as PAD21, PAD31, PAD41, PAD51, PAD61, PAD71, PAD81 or PAD91) and the second voltage terminal (such as PAD22, PAD32, PAD42, PAD52, PAD62, PAD72, PAD82 or PAD92). Therefore, the ESD protection circuits of the above embodiments may prevent ESD from damaging the integrated circuit. Moreover, since the above embodiments use parasitic capacitance to replace large capacitors, it is possible to save the area of the integrated circuits.

## Claims

1. An electrostatic discharge, hereinafter referred to as ESD, protection circuit (200, 300, 400, 500, 600, 700, 800, 900), coupled between a first voltage terminal (PAD21, PAD31, PAD41, PAD51, PAD61, PAD71, PAD81, PAD91) and a second voltage terminal(PAD22, PAD32, PAD42, PAD52, PAD62, PAD72, PAD82, PAD92), and **characterised by** comprising:
a main transistor (B21, B31, B41, B51, B61, B71, B81, B91), having a first terminal, a second terminal, and a control terminal, wherein the first terminal of the main transistor (B21, B31, B41, B51, B61, B71, B81, B91) is coupled to the second voltage terminal (PAD22, PAD32, PAD42, PAD52, PAD62, PAD72, PAD82, PAD92), and the second terminal of the main transistor (B21, B31, B41, B51, B61, B71, B81, B91) is coupled to the first voltage terminal (PAD21, PAD31, PAD41, PAD51, PAD61, PAD71, PAD81, PAD91);
a first resistor element (R21, R31, R41, R51, R61, R71, R81, R91) having a first terminal and a second terminal, wherein the first terminal of the first resistor element (R21, R31, R41, R51, R61, R71, R81, R91) is coupled to the first voltage terminal (PAD21, PAD31, PAD41, PAD51, PAD61, PAD71, PAD81, PAD91); and
a control circuit (210, 310, 410, 510, 610, 710, 810, 910) having a first terminal, a second terminal, an input terminal and an output terminal, wherein the first terminal of the control circuit (210, 310, 410, 510, 610, 710, 810, 910) is coupled to the first voltage terminal (PAD21, PAD31, PAD41, PAD51, PAD61, PAD71, PAD81, PAD91), the second terminal of the control circuit (210, 310, 410, 510, 610, 710, 810, 910) is coupled to the second voltage terminal (PAD22, PAD32, PAD42, PAD52, PAD62, PAD72, PAD82, PAD92), the input terminal of the control circuit (210, 310, 410, 510, 610, 710, 810, 910) is coupled to the second terminal of the first resistor element (R21, R31, R41, R51, R61, R71, R81, R91), the output terminal of the control circuit (210, 310, 410, 510, 610, 710, 810, 910) is coupled to the control terminal of the main transistor (B21, B31, B41, B51, B61, B71, B81, B91), and the control circuit comprises:
a first control transistor (M21, M31, M41, M51, M61, M71, M81, M91) having a first terminal, a second terminal and a control terminal, wherein the first terminal of the first control transistor (M21, M31, M41, M51, M61, M71, M81, M91) is coupled to the first terminal of the control circuit (210, 310, 410, 510, 610, 710, 810, 910), and the control terminal of the first control transistor (M21, M31, M41, M51, M61, M71, M81, M91) is coupled to the input terminal of the control circuit (210, 310, 410, 510, 610, 710, 810, 910); and
a second control transistor (M22, M32, M42, M52, M62, M72, M82, M92) having a first terminal, a second terminal and a control terminal, wherein the first terminal of the second control transistor (M22, M32, M42, M52, M62, M72, M82, M92) is coupled to the second terminal of the control circuit (210, 310, 410, 510, 610, 710, 810, 910), the second terminal of the second control transistor (M22, M32, M42, M52, M62, M72, M82, M92) is coupled to the second terminal of the first control transistor (M21, M31, M41, M51, M61, M71, M81, M91), and the control terminal of the second control transistor is coupled to the input terminal of the control circuit (210, 310, 410, 510, 610, 710, 810, 910); wherein
when an ESD event occurs, a product of a capacitance value of a parasitic capacitance (Cgs, Cgd) of the second control transistor (M22, M32, M42, M52, M62, M72, M82, M92) and a resistance value of the first resistor element (R21, R31, R41, R51, R61, R71, R81, R91) is greater than a duration of the ESD event, and the control circuit (210, 510, 810, 910) is configured to turn on the main transistor (B21, B31, B41, B51, B61, B71, B81, B91) so that an ESD current flows through the main transistor (B21, B31, B41, B51, B61, B71, B81, B91).

2. The ESD protection circuit (200, 500, 600, 900) according to claim 1, **characterised in that** the main transistor (B21, B51, B61, B91) is an N-type transistor, and a size of the main transistor (B21, B51, B61, B91) is larger than a size of the second control transistor (M22, M52, M62, M92).

3. The ESD protection circuit (200, 500, 600, 900) according to claim 2, **characterised in that** when the ESD event occurs, the first control transistor (M21, M51, M61, M91) is turned on, the second control transistor (M22, M52, M62, M92) is turned off, and a potential at the output terminal of the control circuit is high to turn on the main transistor (B21, B51, B61, B91).

4. The ESD protection circuit (200, 500, 600, 900) according to claim 3, **characterised in that** the first control transistor (M21, M51, M61, M91) is a P-type transistor, and the second control transistor (M22, M52, M62, M92) is an N-type transistor.

5. The ESD protection circuit (300, 400, 700, 800) according to claim 1, **characterised in that** the main transistor (B31, B41, B71, B81) is a P-type transistor, and a size of the main transistor (B31, B41, B71, B81) is larger than a size of the second control transistor (M32, M42, M72, M82).

6. The ESD protection circuit (300, 700) according to claim 5, **characterised in that** when the ESD event occurs, the first control transistor (M31, M71) is turned off, the second control transistor (M32, M72) is turned on, and a potential at the output terminal of the control circuit is low to turn on the main transistor (B31, B71).

7. The ESD protection circuit (300, 700) according to claim 6, **characterised in that** the first control transistor (M31, M71) is an N-type transistor, and the second control transistor (M32, M72) is a P-type transistor.

8. The ESD protection circuit (600, 700, 800, 900) according to claim 1, **characterised by** further comprising:
a pull-down circuit (620, 720, 820,920) coupled between the input terminal of the control circuit (610, 710, 810, 910), the first voltage terminal (PAD61, PAD71, PAD81, PAD91) and the second voltage terminal (PAD62, PAD72, PAD82, PAD92),
wherein when the ESD event occurs, a potential at the input terminal of the control circuit (610, 710, 810, 910) is low.

9. The ESD protection circuit (600, 700, 800, 900) according to claim 8, **characterised in that** when a potential difference between the input terminal of the control circuit (610, 710, 810, 910) and the first voltage terminal (PAD61, PAD71, PAD81, PAD91) is lower than a critical voltage, the potential at the input terminal of the control circuit 610, 710, 810, 910) changes from low to high to turn off the main transistor (B61, B71, B81, B91).

10. The ESD protection circuit (900) according to claim 8, **characterised in that** the pull-down circuit (920) is coupled to the first terminal and the second terminal of the first resistor element (R91), and the pull-down circuit (920) comprises:
a third control transistor (M93), wherein a first terminal of the third control transistor (M93) is coupled to the first terminal of the first resistor element (R91), and a control terminal of the third control transistor (M93) is coupled to the input terminal of the control circuit (910); and
a fourth control transistor (M94), wherein a first terminal of the fourth control transistor (M94) is coupled to the second voltage terminal (PAD92), a second terminal of the fourth control transistor is coupled to the input terminal of the control circuit (910), and a control terminal of the fourth control transistor (M94) is coupled to a second terminal of the third control transistor (M93).

11. The ESD protection circuit (900) according to claim 10, **characterised in that** the pull-down circuit further comprises:
a second resistor element (R92), wherein a first terminal of the second resistor element (R92) is coupled to the second terminal of the third control transistor (M93) and the control terminal of the fourth control transistor (M94), and a second terminal of the second resistor element (R92) is coupled to the second voltage terminal (PAD92).

12. The ESD protection circuit (900) according to claim 10, **characterised in that** the third control transistor (M93) is a P-type transistor, the fourth control transistor (M94) is an N-type transistor, when the ESD event occurs, the third control transistor (M93) is turned on, and the fourth control transistor (M94) is turned on, so that the potential at the input terminal of the control circuit (910) is maintained to be low.

13. The ESD protection circuit (500) according to claim 1, **characterised by** further comprising:
a third resistor element (R52), wherein a first terminal of the third resistor element is coupled to the control terminal of the main transistor (B51), and the second terminal of the third resistor element (R52) is coupled to the second voltage terminal (PAD52).

14. The ESD protection circuit (400, 800) according to claim 1, **characterised in that** the control circuit further comprises:
a fifth control transistor (M45, M85) having a first terminal, a second terminal and a control terminal, wherein the first terminal of the fifth control transistor (M45, M85) is coupled to the first terminal of the control circuit (410, 810), the second terminal of the fifth control transistor (M45, M85) is coupled to the output terminal of the control circuit (410, 810), and the control terminal of the fifth control transistor (M45, M85) is coupled to the second terminal of the first control transistor (M41, M81); and
a sixth control transistor (M46, M86) having a first terminal, a second terminal and a control terminal, wherein the first terminal of the sixth control transistor (M46, M86) is coupled to the second terminal of the control circuit (410, 810), the second terminal of the sixth control transistor (M46, M86) is coupled to the second terminal of the fifth control transistor (M45, M85), and the control terminal of the sixth control transistor (M46, M86) is coupled to the second terminal of the second control transistor (M42, M82).

15. The ESD protection circuit (400, 800) according to claim 14, **characterised in that** the main transistor (B41, B81) is a P-type transistor, a size of the main transistor (B41, B81) is larger than a size of the first control transistor (M41, M81), the first control transistor (M41, M81) and the fifth control transistor (M45, M85) are P-type transistors, the second control transistor (M42, M82) and the six control transistor (M46, M86) are N-type transistors, when the ESD event occurs, the first control transistor (M41, M81) is turned on, the second control transistor (M42, M82) is turned off, the fifth control transistor (M45, M85) is turned off, the sixth control transistor (M46, M86) is turned on, a potential at the second terminal of the first control transistor (M41, M81) and a potential at the second terminal of the second control transistor (M42, M82) are high potentials, a potential at the output terminal of the control circuit (410, 810) is low to turn on the main transistor (B41, B81).
